# EUROPEAN PATENT APPLICATION

(11) **EP 4 160 655 A1**
(43) Date of publication of application: **05.04.2023**
(21) Application number: 22198694.6
(22) Date of filing: 29.09.2022
(51) Int. Cl.: H01L 21/28, H01L 21/268, H01L 21/304, H01L 29/34, H01L 29/417, H01L 29/872, H01L 29/06, H01L 29/78, H01L 29/16

(54) **PROCESS FOR MANUFACTURING A VERTICAL CONDUCTION SILICON CARBIDE ELECTRONIC DEVICE AND VERTICAL CONDUCTION SILICON CARBIDE ELECTRONIC DEVICE HAVING IMPROVED MECHANICAL STABILITY**

(30) Priority: 30.09.2021 IT 202100025163
(71) Applicant: STMicroelectronics S.r.l., 20864 Agrate Brianza (MB) (IT)
(72) Inventor: BADALÀ, Paolo, 95024 ACIREALE (CT) (IT); SCUDERI, Valentina, 95127 CATANIA (IT); BASSI, Anna, 95030 GRAVINA DI CATANIA (CT) (IT); BOSCAGLIA, Massimo, 95037 SAN GIOVANNI LA PUNTA (CT) (IT); FRANCO, Giovanni, 95039 VIAGRANDE (CT) (IT)
(74) Representative: Studio Torta S.p.A.

(57) **Abstract**

For the manufacturing of a vertical conduction silicon carbide electronic device, a work wafer (5), which has a silicon carbide substrate (12) having a work face (5B), is processed. A rough face (13A) is formed from the work face of the silicon carbide substrate. The rough face has a roughness higher than a threshold. A metal layer (20) is deposited on the rough face and the metal layer is annealed, thereby causing the metal layer to react with the silicon carbide substrate, forming a silicide layer (50) having a plurality of protrusions (53) of silicide.

## Description

The present invention is relative to a process for manufacturing a vertical conduction silicon carbide electronic device and to a vertical conduction silicon carbide electronic device having improved mechanical stability.

As known, silicon carbide (SiC) electronic devices such as Junction Barrier Schottky (JBS) diodes, Merged PiN Schottky (MPS) diodes and MOSFET transistors, have better performances than silicon electronic devices, in particular for power applications, wherein high operating voltages or other specific operating conditions, such as high temperature, are employed.

A silicon carbide electronic device for power applications, hereinafter indicated as power device, comprises a silicon carbide body, a front metal region and a back metal region. In use, a current may flow through the silicon carbide body between the front metal region and the back metal region.

It is known to obtain the power device from a silicon carbide wafer having a front surface and a back surface, in one of its polytypes, such as 3C-SiC, 4H-SiC and 6H-SiC.

During initial manufacturing steps, devices like transistors, diodes, resistors, etc. are generally formed in the silicon carbide body from the front surface. Then, the front metal region is formed on the front surface to mutually interconnect the integrated devices as well as to allow connection of the power device with external circuit components and/or stages.

In addition, the back surface of the wafer is processed, so as to form the back metal region.

To this end, a metal layer, e.g. nickel or titanium, is deposited on the back surface.

Then, a laser beam is used to heat the metal layer and cause the metal layer to fully react with the silicon carbide of the wafer, thereby forming a silicide layer, e.g. titanium or nickel silicide.

Subsequently, a metallization layer is deposited on the silicide layer.

After final manufacturing steps including dicing, the power device is obtained.

The Applicant has verified that, in some cases, the silicide layer of such known power devices has a low mechanical stability. In fact, during some reliability tests, it has been observed that the silicide layer has a high probability of delamination from the silicon carbide body or mechanical fracture, thereby causing failure of the power device.

The aim of the present invention is to overcome the disadvantages of the prior art.

According to the present invention, a process for manufacturing a vertical conduction silicon carbide electronic device and a vertical conduction silicon carbide electronic device are provided, as defined in the attached claims.

For a better understanding of the present invention, a non-limiting embodiment is now described, with reference to the attached drawings, wherein:
- figure 1 shows a cross-section of a work body comprising a silicon carbide wafer, according to the present manufacturing process;
- figure 2 is a top plan view of the work body of figure 1;
- figures 3-7 are cross-sections of the work body of figure 1 in subsequent manufacturing steps;
- figure 8 is an exemplificative micrograph of a surface of the work body of figure 7;
- figure 9 is an enlarged detail of the micrograph of figure 8;
- figure 10 is a cross-section of the work body of figure 7 in a subsequent manufacturing step; and
- figure 11 is a cross-section of the present electronic device.

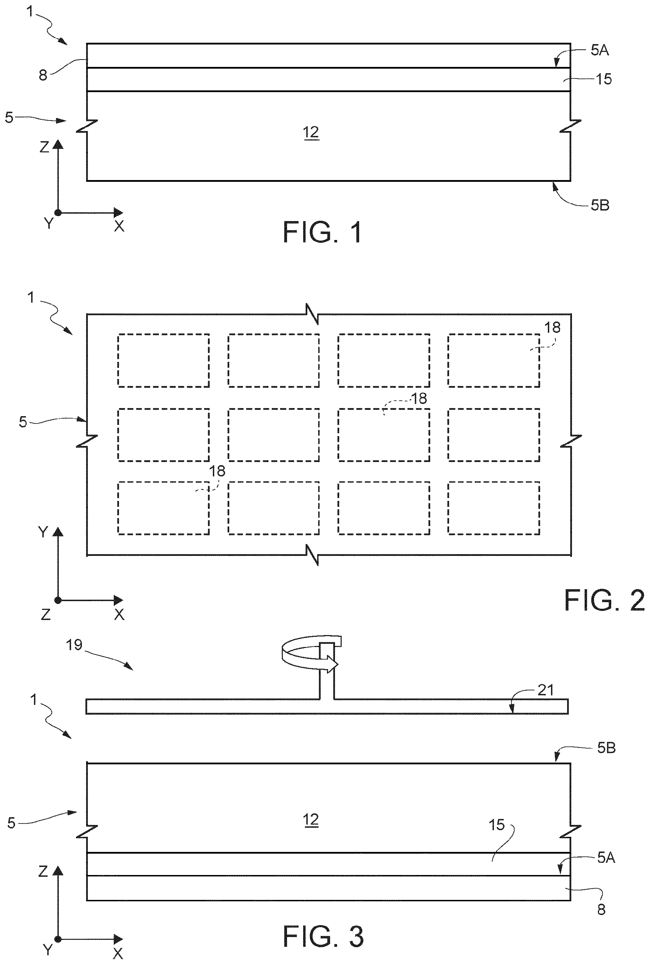

Figures 1 and 2 show a work body 1 in a Cartesian reference system XYZ comprising a first axis X, a second axis Y and a third axis Z.

The work body 1 has already been subject to first manufacturing steps.

The work body 1 is formed by a wafer 5 of silicon carbide (SiC) in one of its polytypes, such as 3C-SiC, 4H-SiC and 6H-SiC, having a first surface 5A and a second surface 5B, and by a connection structure layer 8 extending on the first surface 5A of the wafer 5.

The wafer 5 comprises a work substrate 12, which forms the second surface 5B of the wafer 5 and has a thickness comprised for example between 275 µm and 375 µm, in particular of about 350 µm, and a device layer 15, which forms the first surface 5A of the wafer 5 and extends directly on the work substrate 12.

The device layer 15 may be a portion of the work substrate 12 or may be an epitaxial layer grown on the work substrate 12.

The device layer 15 comprises current conduction zones, here not shown, whose structure, number and configuration depend on the specific application.

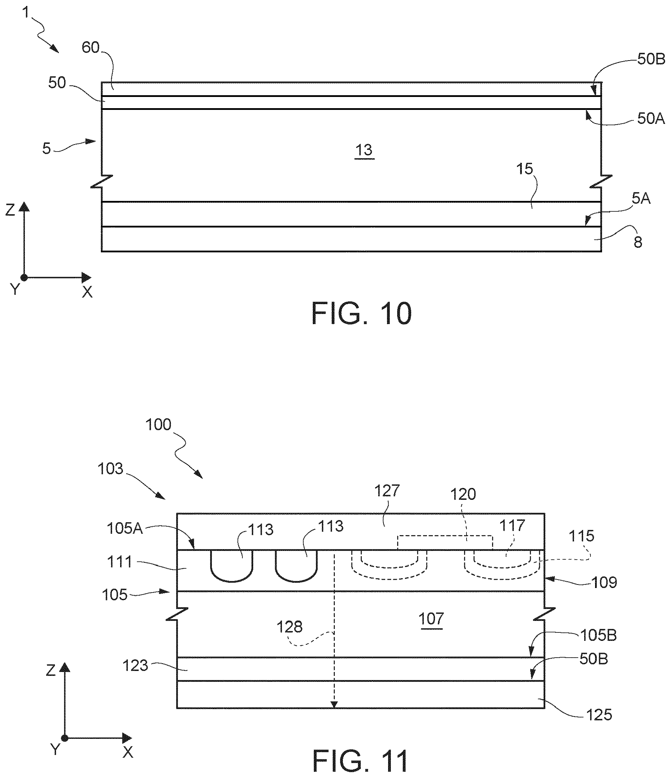

For example, the device layer 15 may comprise a drift layer and one or more implanted regions which may form, for example, source regions and body regions, depending on the specific application, examples whereof are shown for illustrative purposes in figure 11.

In an embodiment, the device layer 15 may also comprise gate structures. In another embodiment, the device layer 15 may be a multilayer, with different device structures integrated in the various layers.

The connection structure layer 8 comprises one or more metal layers that form an electrical interconnect structure for the device layer 15.

According to an embodiment, the connection structure layer 8 may also comprise one or more layers of insulating materials, forming passivation structures.

The device layer 15 and the connection structure layer 8 form at least one die portion, here a plurality of die portions 18.

Each die portion 18 is intended to form a respective electronic device, after dicing the work body 1.

Each die portion 18 has a die area, which occupies a respective portion of the area of the first surface 5A of the wafer 5.

In figure 2, for simplicity, the die portions 18 are schematically indicated by dashed lines.

In detail, in this embodiment, each die portion 18 has a rectangular shape in top plan view. By way of example only, the die area may be approximately of few millimeters squared, for example approximately 4 mm by 5 mm.

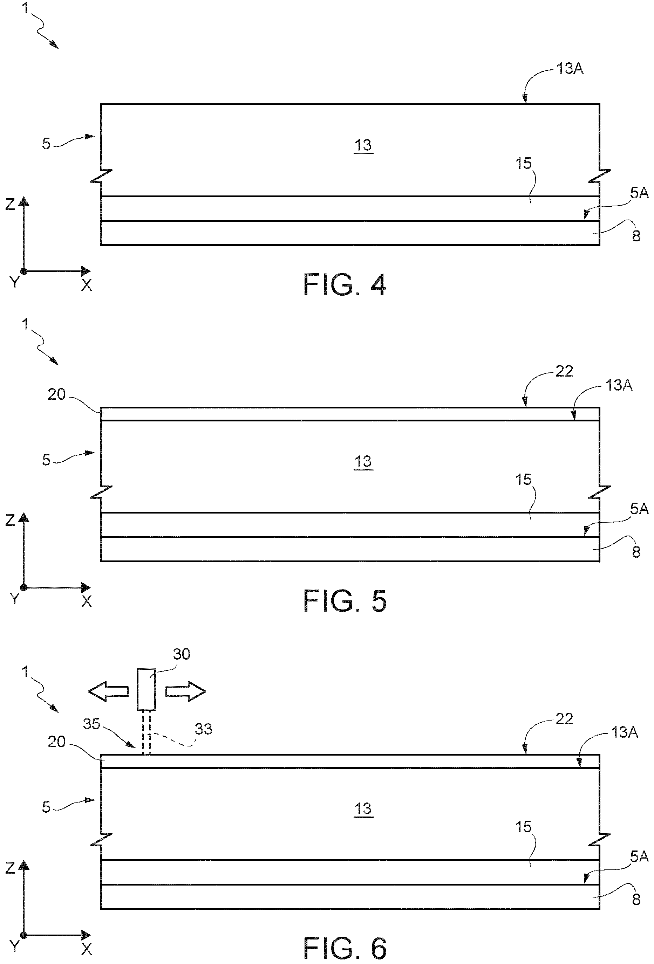

Subsequently, as shown in figures 3 and 4, the work substrate 12 undergoes a thinning step, thereby forming a thinned substrate 13 having a rough surface 13A.

In this embodiment, as shown in figure 3, the work body 1 is flipped upside down and the work substrate 12 is thinned from the second surface 5B of the wafer 5.

However, the work substrate 12 may be thinned without flipping the work body 1 upside down, for example depending on the specific machinery used in the thinning step.

In detail, here, the second surface 5B of the wafer 5 undergoes grinding by using a grinding wheel 19 having an abrasive surface 21.

The work substrate 12 is thinned by applying a friction between the abrasive surface 21 and the second surface 5B of the wafer 5, for example here by applying a relative rotation between the grinding wheel 19 and the work body 1 around an axis parallel to the third axis Z.

Figure 4 shows the work body 1 after thinning of the work substrate 12 and therefore the formation of the thinned substrate 13.

The thinned substrate 13 has a thickness comprised, for example, between 100 µm and 250 µm, in particular of about 180 µm, and extends between the device layer 15 and the rough surface 13A.

In practice, after the thinning step, the rough surface 13A of the thinned substrate 13 forms the second surface of the wafer 5, which is therefore also indicated by 13A.

The rough surface 13A has a roughness, for example measurable in a known way by an Atomic Force Microscopy (AFM), having a root mean square value (RMS) which is equal to or higher than 30 nm, for example comprised between 30 nm and 100 nm.

The abrasive surface 21 of the grinding wheel 19 is specifically chosen, at the design stage, so to obtain said roughness of the rough surface 13A. For example, the abrasive surface 21 is chosen to have a coarse mesh, with mesh size comprised, for example, between 500 and 1500, in particular of about 1000. The abrasive surface 21 comprises in fact abrasive grains; a higher mesh size indicates a smaller size of the abrasive grains and may be used to obtain a smaller roughness of the rough surface 13A.

Then, figure 5, a contact layer 20 is deposited on the rough surface 13A, forming a contact surface 22 of the work body 1.

The contact layer 20 is a metal material such as nickel, titanium or an alloy of nickel and silicon, and has a thickness, measured parallel to the third axis Z, comprised for example between 10 nm and 200 nm, in particular of about 100 nm.

Subsequently, figure 6, the work body 1, in particular the contact layer 20, undergoes an annealing step, in particular a laser annealing.

In detail, a laser source 30 is used to generate a light beam 33 and focus the light beam 33 on the contact surface 22.

The light beam 33 has an energy density higher than 3 J/cm², for example comprised between 3.0 J/cm² and 4.4 J/cm², in particular of 3.8 J/cm².

The light beam 33 has a wavelength comprised, for example, between 290 nm and 370 nm, in particular of 310 nm.

The light beam 33 may be a pulsed light beam wherein each laser pulse has a duration comprised, for example, between 100 ns and 300 ns, in particular of 160 ns.

The light beam 33 has a beam footprint 35 on the contact surface 22.

The beam footprint 35 may form a polygonal shape, a circular shape or any other shape, in particular a squared shape, on the contact surface 22.

During the annealing step, the laser source 30 focuses the laser beam 33 on the contact surface 22, i.e. the beam footprint 35 forms an irradiated portion of the contact surface 22.

For example, each portion of the contact surface 22 may be irradiated by one or more pulses or shots of the laser beam 33, for example comprised between one and five.

The laser beam 33 is absorbed by the contact layer 20 and by part of the thinned substrate 13. The absorbed light generates heat locally, i.e. immediately under the irradiated portion of the contact surface 22, for example to a depth of few microns from the contact surface 22.

The generated heat makes the contact layer 20 and the thinned substrate 13 to react locally, at a respective portion of the rough surface 13A, forming a silicide, for example nickel silicide or titanium silicide.

According to an embodiment, the beam footprint 35 may have an area much smaller than the contact surface 22.

For example, the beam footprint 35 may have a side, in the case of squared shape, comprised, for example, between 8 mm and 36 mm, in particular may be about 10 mm.

Therefore, in order to cause the reaction of the entire contact layer 20 with the thinned substrate 13, the contact surface 22 may be scanned using a step-and-repeat approach.

The contact surface 22 may be scanned by moving the beam footprint 35, between two adjacent irradiated portions of the contact surface 22, by a step that is approximately equal to the side of the beam footprint 35.

In practice, at a first approximation, the beam footprint 35 may be moved, with respect to contact surface 22, so that there is no overlap between two adjacent irradiated portions of the contact surface 22. Accordingly, the throughput of the laser annealing step may be maximised.

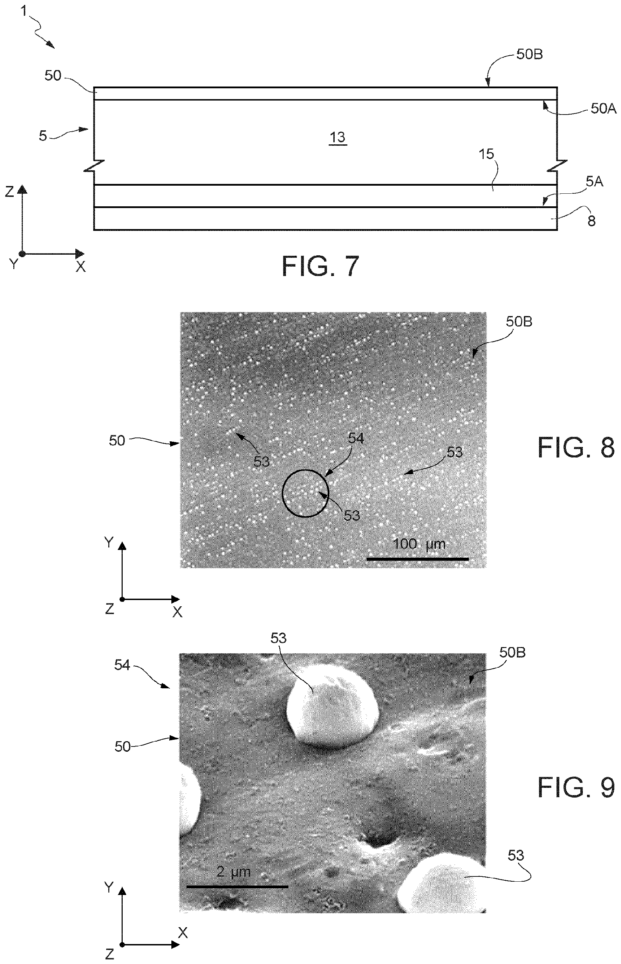

Figure 7 shows the work body 1 after the contact surface 22 has been completely exposed by the laser beam 33, thereby causing the complete reaction of the contact layer 20 with the thinned substrate 13 and formation of an ohmic layer 50.

The ohmic layer 50 is of silicide and extends between a first surface 50A, which corresponds to the rough surface 13A, and a second surface 50B, which corresponds to the contact surface 22.

The ohmic layer 50 may be thicker than the contact layer 20, since also part of the thinned substrate 13 has reacted to form the ohmic layer 50.

Figure 8 is an exemplificative micrograph of a portion of the second surface 50B of the ohmic layer 50.

The second surface 50B of the ohmic layer 50 comprises a plurality of protrusions 53, of silicide, which are visible in figure 8 as bright spots on the second surface 50B of the ohmic layer 50.

Figure 9 is a zoomed-in micrograph of part of an area 54 of the second surface 50B of the ohmic layer 50 identified by a circle in figure 8.

The protrusions 53 substantially have each a spherical shape and a diameter comprised, for example, between 0.5 µm and 2 µm, in particular between 1 µm and 2 µm.

However, the protrusions 53 may have a different shape and each have a height, measured parallel to the third axis Z, and/or a width, measured parallel to the first axis X and/or the second axis Y, which is comprised between 0.5 µm and 2 µm, in particular between 1 µm and 2 µm.

The protrusions 53 have a density on the second surface 50B of the ohmic layer 50 that is higher than 2000 protrusions/mm², in particular comprised between 2000 protrusions/mm² and 20000 protrusions/mm².

The density and the distribution of the protrusions 53 depends on the roughness of the rough surface 13A. For example, the protrusions 53 may be randomly distributed on the second surface 50B of the ohmic layer 50 or may have a specific distribution, depending on the machinery and parameters used during the thinning step.

Moreover, the size of the protrusions 53 may be adjusted by tuning the roughness of the rough surface 13A, the thickness of the contact layer 20, and the parameters of the annealing step, e.g. on the parameters of the laser beam 33.

In fact, the roughness of the rough surface 13A enhances an uneven nucleation of the atoms during the silicide reaction between the contact layer 20 and the thinned substrate 13, i.e. during the annealing step, thereby forming the protrusions 53 of silicide.

In figure 10, a metallization layer 60 is deposited on the second surface 50B of the ohmic layer 50. The metallization layer 60 may be a single metal layer or a stack of different metal layers, for example Ti/NiV/Ag.

The metallization layer 60 is useful for subsequent manufacturing steps, for example assembling processes such as sintering and diffusion soldering.

The work body 1 is then subject to known final manufacturing steps, such as dicing, thereby forming an electronic device 100 (figure 11) for each die portion 18.

The electronic device 100 comprises a die 103 including a body 105 having a first surface 105A, which corresponds to the first surface 5A of the wafer 5, and a second surface 105B, which corresponds to the first surface 50A of the ohmic layer 50.

The body 105 comprises a substrate 107 (corresponding to the thinned substrate 13 and forming the second surface 105B) and a device region 109 (corresponding to the device layer 15 and forming the first surface 105A).

The device region 109, as discussed above for the device layer 15, accommodates functional regions of various kind and dimensions, according to the specific type of the electronic device 100 and the specific application.

By way of example, the electronic device 100 may be a JBS or an MPS diode. In this case, as shown in figure 11 by way of example, the device region 109 forms a drift region 111 of a first conductivity type, e.g. N-type, accommodating two implanted regions 113 of a second conductivity type, e.g. P-type.

As an alternative, as also shown as an example in figure 11, the electronic device 100 may be a MOSFET device. In this case, the drift region 111 accommodates body regions 115 of the second conductivity type, source regions 117 of the first conductivity type and insulated gate regions 120 of dielectric material (represented with dashed lines in figure 11).

The die 103 comprises an ohmic connection region 123, corresponding to the ohmic layer 50, extending on the second surface 105B of the body 105 and forming a metallization contact surface, which corresponds to the second surface 50B of the ohmic layer 50 and therefore it is indicated by the same reference number.

The die 103 also comprises a back metallization region 125 corresponding to the metallization layer 60 and extending on the metallization contact surface 50B.

The die 103 further comprises a connection structure region 127 corresponding to the connection structure layer 8, extending on the first surface 105A of the body 105.

In detail, the device region 109 and the connection structure region 127 correspond to a respective die portion 18 (figure 2).

In use, the electronic device 100 has a current path 128, schematically represented by a dashed arrow in figure 11, which extends between the connection structure region 111 and the back metallization region 125, through the body 105.

In use, a current may flow through the current path 128, depending on the specific structure of the device region 109, i.e. on the type of the electronic device 100.

The ohmic connection region 123 shows a high mechanical stability.

The ohmic connection region 123 comprises, on the second surface 50B, the protrusions 53 described with reference to figures 8 and 9, the number thereof being a function of the area of the second surface 50B of the ohmic connection region 123 and the density of the protrusions 53.

For example, by considering the density of the protrusions 53 to be 2000 protrusions/mm² and the area of the second surface 50B of the ohmic connection region 123 to be, by way of example only, about 10 mm², the second surface 50B of the ohmic connection region 123 has a number of protrusions approximately equal to 2·10⁴.

The Applicant has verified that the protrusions 53 work as anchoring regions of the ohmic connection region 123, thereby increasing the mechanical robustness thereof. The electronic device 100 is therefore less subject to mechanical defects such as fracture and delamination of the ohmic connection region 123.

In particular, a shear test of the electronic device 100, performed by the Applicant, shows an average increase of the shear strength of the electronic device 100 of about 24% with respect to a case wherein the electronic device 100 has been manufactured without forming the rough surface 13A.

Moreover, a shear test of the electronic device 100, performed by the Applicant after subjecting test devices to one hundred thermal cycles, shows an average increase of the shear strength of the electronic device 100 up to 99% with respect to the case wherein the electronic device 100 has been manufactured without forming the rough surface 13A.

At the same time, the ohmic connection region 123 ensures a good electrical contact, in particular an ohmic contact, with the substrate 107. Therefore, the electronic device 100 also maintains good electrical properties.

Moreover, the fact that the substrate 107 is thin, e.g. comprised between 100 µm and 250 µm, in particular is of about 180 µm, and the presence of the protrusions 53 allow to reduce the on-resistance of the current path 128. Therefore, the electronic device 100 has a low power consumption.

In addition, it is possible to optimize the throughput of the laser annealing step of figure 6, i.e. by scanning the contact surface 22 without overlapping adjacent irradiated portions of the contact surface 22. Accordingly, the manufacturing costs of the electronic device 100 may be kept low.

It should be noted that wafer substrate thinning, by mechanical grinding of hundreds of microns of substrate material in reasonable process time, usually requires the use of a grinding wheel with abrasive grain of large size. This leaves a highly constrained layer on the backside of the wafer, causing high levels of bow and warpage on the wafer, which make the handling of the wafer difficult in subsequent manufacturing process steps. Thus, in conventional wafer thinning, a second grinding wheel is used, with abrasive grain of smaller size, that results in a smooth, weakly strained backside surface. For silicon substrate wafers, a further chemical attack is conventionally performed of the wafer backside to remove a portion of the residual strained top layer and reduce even more the wafer backside roughness and wafer bow/warpage. However, there is no convenient chemistry for silicon carbide wafer substrates, so the second grinding wheel grain size and grinding process parameters are chosen to achieve a smooth wafer backside, of root mean square value (RMS) which is typically lower than 10 nm, for example comprised between 10 nm and 3 nm.

Although a smooth, low constraint level wafer backside is desirable for wafer handling, the inventors discovered that, surprisingly, keeping a rough backside surface highly increases the mechanical robustness of the ohmic region and its adhesion to the silicon carbide substrate. At the expense of a little bit more difficult wafer handling, still deemed acceptable, this can solve the fracture and delamination issues associated with ohmic region in vertically integrated power devices formed on silicon carbide substrate.

It is clear that the present manufacturing method and the corresponding electronic device may be subject to modifications and variations without departing the scope of the present invention, as defined in the attached claims.

The rough surface 13A may be obtained by increasing the roughness of the second surface 5B of the wafer 5 without thinning of the work substrate 12, for example through other specific chemical and/or physical surface treatments.

The thinning step of the work substrate 12 may be performed through a process different from grinding, for example laser cutting, designed to obtain the thinned substrate 13 having the rough surface 13A.

## Claims

1. A process for manufacturing a vertical conduction silicon carbide electronic device from a work wafer (5) comprising a silicon carbide substrate (12) having a work face (5B), the process comprising:
- forming a rough face (13A) from the work face of the silicon carbide substrate, the rough face having a roughness higher than a threshold;
- depositing, on the rough face, a metal layer (20); and
- annealing the metal layer, thereby causing the metal layer to react with the silicon carbide substrate, forming a silicide layer (50) having a plurality of protrusions (53) of silicide.

2. The process according to the preceding claim, wherein the threshold is a root mean square value of the roughness of the rough face (13A), the root mean square value being equal to or higher than 30 nm.

3. The process according to claim 1 or 2, wherein forming a rough face (13A) comprises thinning the silicon carbide substrate (12) from the work face (5B), thereby forming a thinned layer (13) having the rough face (13A).

4. The process according to the preceding claim, wherein the thinned layer (13) is formed by grinding the silicon carbide substrate, on the work face, with an abrasive surface (21).

5. The process according to the preceding claim, wherein the abrasive surface has a mesh size comprised between 1500 and 500.

6. The process according to any of claims 3-5, wherein the thinned layer (13) has a thickness comprised between 100 µm and 250 µm.

7. The process according to any of the preceding claims, wherein the metal layer (20) has a contact face (22) and annealing the metal layer comprises laser annealing the contact face of the metal layer with a laser beam (33).

8. The process according to the preceding claim, wherein the laser beam (33) has a footprint (35) smaller than the contact face and laser annealing comprises scanning the entire contact face (22) with the laser beam (33) using a step-and-repeat type of scanning.

9. The process according to claim 7, wherein the laser beam (33) has a footprint (35) on the contact face (22), laser annealing the contact face comprising scanning the contact face so that two adjacent irradiated portions of the contact face have approximately zero mutual overlap.

10. The process according to any of claims 7-9, wherein the laser beam (33) has an energy density higher than 3 J/cm².

11. The process according to any of the preceding claims, further comprising depositing a metallization layer (60) on the silicide layer (50).

12. A vertical conduction silicon carbide electronic device formed in a die (103) comprising:
- a body (105, 107) of silicon carbide; and
- a contact region (123) of silicide extending on the body and forming a connection surface (50B),
wherein the contact region comprises a plurality of protrusions (53) of silicide, the plurality of protrusions having a density, on the connection surface, that is higher than a threshold.

13. The device according to the preceding claim, wherein the threshold is about 2000 protrusions/mm².

14. The device according to claim 12 or 13, wherein each protrusion has a size comprised between 0.5 µm and 2 µm.
